# EUROPEAN PATENT APPLICATION

(11) **EP 1 592 290 A1**
(43) Date of publication of application: **02.11.2005**
(21) Application number: 05007458.2
(22) Date of filing: 05.04.2005
(51) Int. Cl.: H05K 3/38, H05K 3/24

(54) **Wired circuit board and production method thereof**

(30) Priority: 30.04.2004 JP 2004135465
(71) Applicant: NITTO DENKO CORPORATION, Ibaraki-shi, Osaka 567-8680 (JP)
(72) Inventor: Tsunekawa, Makoto, Ibaraki-shi Osaka 567-8680 (JP); Nakamura, Kei, Ibaraki-shi Osaka 567-8680 (JP); Toyozawa, Keiko, Ibaraki-shi Osaka 567-8680 (JP); Yamato, Takeshi, Ibaraki-shi Osaka 567-8680 (JP); Baba, Toshikazu, Ibaraki-shi Osaka 567-8680 (JP)
(74) Representative: Schwabe - Sandmair - Marx

(57) **Abstract**

A wired circuit board which is formed so that even when a wired circuit pattern is formed at a fine pitch and then a tin plating layer is formed on the wired circuit pattern by the electroless tin plating, a wiring of the wired circuit pattern can be prevented from being stripped, and a production method of the same wired circuit board. After a thin metal film 2 formed of nickel-chromium alloy having a chromium content of 8-20weight% is formed on an insulating layer 1, a wired circuit pattern 4 of copper is formed on the thin metal film 2. Then, a tin plating layer 5 is formed on exposed surfaces of the wired circuit pattern 4 by electroless tin plating.

## Description

### BACKGROUND OF THE INVENTION

### Field of the Invention

The present invention relates to a wired circuit board and to a production method thereof. More particularly, the present invention relates to a wired circuit board applied to a TAB tape carrier and the like and to a production method thereof.

### Description of the Prior Art

A wired circuit board for mounting electronic components thereon, such as, for example, a TAB tape carrier, is plated with tin at terminal portions thereof (inner leads and outer leads) bonded to the electronic components, in order to be bonded to the electronic components by soldering, for example (e.g. JP Laid-open (Unexamined) Patent Publication No. Hei 10-50774).

In the wired circuit board technology, a subtractive process and an additive process are known as a patterning process of the wired circuit pattern. In accordance with the advance of high density of the electronic components in recent years, improvement to fine pitch of the wired circuit pattern is increasingly demanded. Usually, the additive process is said to be advantageous to realization of the improvement to fine pitch of the wired circuit pattern.

For example when the additive process is used to form the TAB tape carrier, a thin chromium film and a thin copper film are sequentially laminated on an insulating layer by continuous sputtering, to form a thin metal film. Then, a wired circuit pattern formed of copper is formed on the thin metal film by the electrolytic copper plating. Then, after required treatments are made, the wired circuit pattern is plated with tin at terminal portions thereof by the electroless tin plating, to form a tin plating layer on the terminal portions.

In the additive process mentioned above, when the wired circuit pattern is formed at a fine pitch (of e.g. 15 *µ* m or less in line width), there is a possibility that the lines of wire of the wired circuit pattern may be stripped in the process of the electroless tin plating.

From the investigation of the causes of this, the inventors found that the thin chromium film of the thin metal film is melted by a plating solution of the electroless tin plating, causing the stripping of the wiring.

The plating solution used for the electroless tin plating is a strongly acidic solution of pH 1 or less. Usually, chromium or copper is not melted in itself by the plating solution of the electroless tin plating. However, when chromium and copper which are different in ionization tendency from each other are dipped in the plating solution of the electroless tin plating in the state of contacting with each other, a local cell is formed in the solution, giving rise to the phenomenon that the chromium higher in ionization tendency than the copper is melted.

This phenomenon is known as the local cell. This phenomenon does not present so significant defects in the wired circuit pattern of a not-so-fine pitch, but it causes the stripping of the wiring in the wired circuit pattern of a fine pitch, as mentioned above.

### SUMMARY OF THE INVENTION

It is an object of the invention to provide a wired circuit board which is formed so that even when a wired circuit pattern is formed at a fine pitch and then a tin plating layer is formed on the wired circuit pattern by the electroless tin plating, a wiring of the wired circuit pattern can be prevented from being stripped, and a production method of the same wired circuit board.

The present invention provides a wired circuit board comprising an insulating layer, a thin metal film formed on the insulating layer and formed of nickel-chromium alloy having a chromium content of 8-20weight%, a wired circuit pattern formed on the thin metal film and formed of copper, and a tin plating layer formed on the wired circuit pattern by electroless tin plating.

In the wired circuit board of the present invention, since the thin metal film is formed of nickel-chromium alloy having a chromium content of 8-20weight%, the thin metal film can be prevented from being melted by electroless tin plating. This can produce the result of preventing the stripping of the wired circuit pattern.

In the wired circuit board of the present invention, it is preferable that each line of wire of the wired circuit pattern has a width of 15 *µ* m or less.

Also, the present invention provides a production method of a wired circuit board comprising the process of preparing an insulating layer, the process of forming on the insulating layer a thin metal film of nickel-chromium alloy having a chromium content of 8-20weight%, the process of forming a wired circuit pattern of copper on the thin metal film, and the process of forming a tin plating layer on the wired circuit pattern by electroless tin plating.

In the production method of the wired circuit board of the present invention, since the thin metal film formed of nickel-chromium alloy having a chromium content of 8-20weight% is formed in the process of forming the thin metal film, the thin metal film can be prevented from being melted by electroless tin plating in the process of forming a tin plating layer by the electroless tin plating. This can produce the result of preventing the stripping of the wired circuit pattern.

In the production method of the wired circuit board of the present invention, it is preferable that the wired circuit pattern is formed so that each line of wire of the wired circuit pattern has a width of 15 *µ* m or less.

According to the wired circuit board of the present invention and the production method thereof, even when the wired circuit pattern is formed at a fine pitch and then the tin plating layer is formed on the wired circuit pattern by the electroless tin plating, the stripping of the lines of wire of the wired circuit pattern can be prevented. This results in realization of improved reliability of the wired circuit board.

### DESCRIPTION OF THE DRAWINGS

In the drawings:

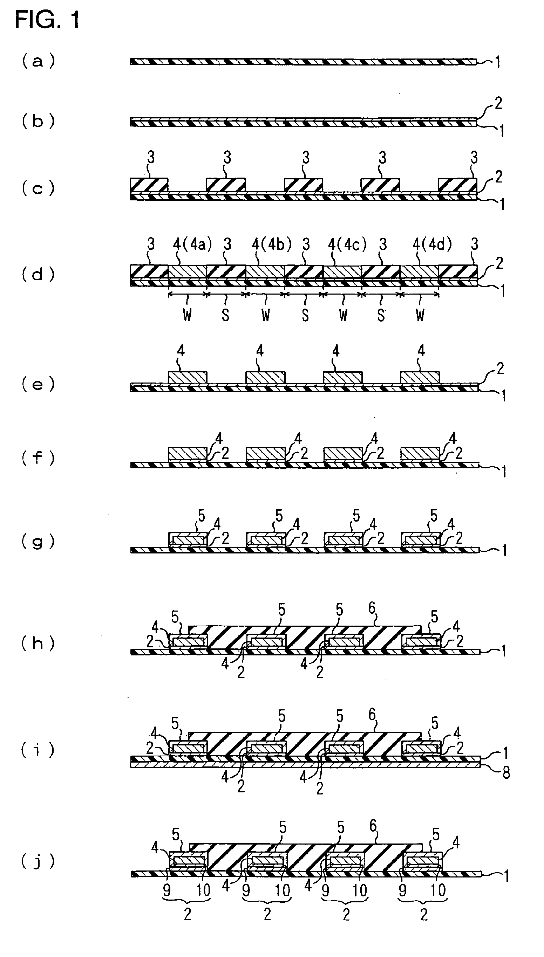

FIG. 1 is a production process drawing showing production processes of a flexible wired circuit board taken as an embodiment of a production method of a wired circuit board of the present invention;
   (a) shows the process of preparing an insulating layer;
   (b) shows the process of forming a thin metal film on the insulating layer;
   (c) shows the process of forming on the thin metal film a plating resist with a reverse pattern to a wired circuit pattern; and
   (d) shows the process of forming the wired circuit pattern on the thin metal film exposed from the plating resist;
   (e) shows the process of removing the plating resist;
   (f) shows the process of removing the thin metal film at a portion thereof exposed from the wired circuit pattern;
   (g) shows the process of forming a tin plating layer on exposed surfaces of the wired circuit pattern by electroless tin plating;
   (h) shows the process of forming a covering layer to cover the wired circuit pattern;
   (i) shows the process of forming the thin metal film, the wired circuit pattern, the tin plating layer and the covering layer in sequence on the insulating layer formed on a metal supporting layer; and
   (j) shows the process of forming the thin metal film comprising a first thin metal film and a second thin metal film on the insulating layer and then forming the wired circuit pattern, the tin plating layer and the covering layer in sequence on the thin metal film.

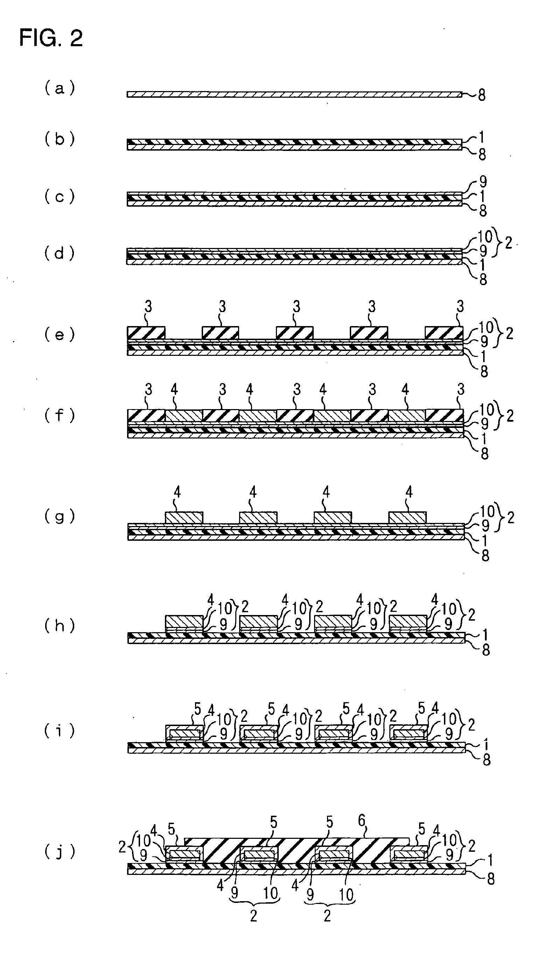

FIG. 2 is a production process drawing showing production processes of a TAB tape carrier of Examples of the present invention and Comparative Examples;
   (a) shows the process of preparing a metal supporting layer,
   (b) shows the process of forming an insulating layer of polyimide on the metal supporting layer;
   (c) shows the process of forming a first thin metal film of a nickel-chromium alloy on the insulating layer;
   (d) shows the process of forming a second thin metal film of copper on the first thin metal film, to form a thin metal film,
   (e) shows the process of forming on the thin metal film a plating resist with a reverse pattern to a wired circuit pattern;
   (f) shows the process of forming the wired circuit pattern on the thin metal film exposed from the plating resist;
   (g) shows the process of removing the plating resist;
   (h) shows the process of removing the thin metal film at a portion thereof where the plating resist was formed;
   (i) shows the process of forming a tin plating layer on exposed surfaces of the wired circuit pattern by electroless tin plating; and
   (j) shows the process of forming a covering layer to cover the wired circuit pattern.

### DETAILED DESCRIPTION OF THE PREFERRED EMBODIMENTS

Referring to FIG. 1, which shows production processes of a flexible wired circuit board taken as an embodiment of a production method of a wired circuit board of the present invention, the production method of this flexible wired circuit board will be explained below.

In this method, an insulating layer 1 is prepared, first, as shown in FIG. 1(a). The material of the insulating layer 1 is not limited to any particular one, as long as it can be used for the insulating layer of the flexible wired circuit board. The insulating materials that may be used include, for example, synthetic resins in film form, such as polyimide resin, polyamide imide resin, acrylic resin, polyether nitrile resin, polyether sulfonic resin, polyethylene terephthalate resin, polyethylene naphthalate resin and polyvinyl chloride resin. A polyimide resin film is preferably used. The insulating layer 1 has a thickness of e.g. 5-50 *µ* m, or preferably 10-40 *µ* m.

Then, a thin metal film 2 of a nickel-chromium alloy is formed on the insulating layer 1, as shown in FIG. 1(b). The nickel-chromium alloy, which is a metal made by combining nickel and chromium, has a chromium content of 8-20weight%, or preferably 15-20weight%. When it has a chromium content of less than 8weight%, its chemical resistance against the plating solution of the electroless tin plating may reduce in the electroless tin plating process (FIG. 1(g)) mentioned later. On the other hand, when it has a chromium content of more than 20weight%, an unwanted part of the thin metal film 2 mentioned later (a part of the thin metal film 2 exposed from the wired circuit pattern) may not be removed easily in the etching process (FIG. 1(f)).

The thin metal film 2 is formed by a known thin film forming method, such as an electroless plating and a vacuum deposition method. It is preferably formed by sputtering using a target of the nickel-chromium alloy. In the formation of this thin metal film 2, the thin metal film 2 is formed to have a thickness in the range of e.g. 70-500Å. When the thin metal film 2 has a thickness of less than 70 Å, it cannot wholly cover over the insulating layer 1 for example and, as a result, for example a pinhole may be produced in the film to cause reduction in reliability of the wired circuit board. On the other hand, when the thin metal film 2 has a thickness of more than 500Å, for example the unwanted part of the thin metal film 2 may not be removed easily in the etching process of the unwanted part of the thin metal film 2 (FIG. 1(f)) mentioned later.

Then, a wired circuit pattern 4 of copper is formed on the thin metal film 2. The wired circuit pattern 4 is formed using a known patterning process, such as the additive process and the subtractive process, without being limited to any particular one. The additive process is preferably used from the viewpoint that the wired circuit pattern 4 is formed at a fine pitch.

In the additive process, a plating resist 3 of a pattern reverse to the wired circuit pattern 4 is formed on the thin metal film 2 formed on the insulating layer 1, as shown in FIG. 1(c). The plating resist 3 is formed in the reverse pattern to the wired circuit pattern by known processes of for example laminating a dry film photoresist on the thin metal film 2, then exposing the dry film photoresist to light, and developing it.

Then, the wired circuit pattern 4 of copper is formed on the thin metal film 2 exposed from the plating resist 3, as shown in FIG. 1(d). No particular limitation is imposed on the method of forming the wired circuit pattern 4, as long as it can allow the formation of the wired circuit pattern 4 of copper. Preferably, the electrolytic copper plating is used.

The wired circuit pattern 4 includes a plurality of lines of wire formed at a fine pitch and is arranged along e.g. a longitudinal direction of the flexible wired circuit board. The plurality of lines of wire (four lines of wire 4a, 4b, 4c, 4d are depicted in FIG. 1(d)) are spaced apart at a predetermined interval and arrayed in parallel with each other in a widthwise direction orthogonal to the longitudinal direction. A width of each line of wire (designated by W in FIG. 1(d)) is for example 15 *µ m* or less, or preferably in the range of 5-15 *µ* m, and a space between two adjoining lines of wire (designated by S in FIG. 1(d)) is for example 15 *µ* m or less, or preferably in the range of 5-15 *µ* m. Also, a thickness of the wired circuit pattern 4 is for example 5 *µ* m or more, or preferably in the range of 5-12 *µ* m.

Thereafter, the plating resist 3 is removed by a known etching process, such as a chemical etching (wet etching), or by stripping, as shown in FIG. 1(e). Then, a part (an unwanted part) of the thin metal film 2 exposed from the wired circuit pattern 4 is removed, as shown in FIG. 1(f). A known etching process, such as a chemical etching (wet etching), is used for the removal of the unwanted part of the thin metal film 2.

Then, a tin plating layer 5 is formed on exposed surfaces of the wired circuit pattern 4 by electroless tin plating, as shown in FIG. 1(g). The tin plating layer 5 is formed on top and both widthwise lateral side surfaces of each of the lines of wire of the wired circuit pattern 4.

A known plating solution of strongly acidic solution of e.g. pH 1 or less is used for the electroless tin plating. For example, the electroless tin plating solution (Trade name: LT-34) available from Rohm and Haas Co. is used for the electroless tin plating. Setting the temperature of the plating solution at e.g. 60-75°C , the electroless tin plating is carried out for 3-5 minutes. A thickness of the tin plating layer 5 is for example in the range of 0.2-0.6 *µ* m, or preferably 0.4-0.6 *µ* m.

In the electroless tin plating, since the wired circuit pattern 4 is formed of copper, the wired circuit pattern 4 is etched by substitution of tin for copper and then the each line of wire of the wired circuit pattern 4 etched is covered with the tin plating layer 5 to the extent corresponding to the thickness thereof reduced with respect to the respective thin metal film 2, as shown in FIG. 1(g). As a result of this, the thin metal film 2 at the bottom of the each line of wire is exposed at both widthwise end faces thereof, while the each line of wire on the thin metal film 2 is covered with the tin plating layer 5 at both lateral side faces thereof and a top surface thereof.

Then, a covering layer 6 is formed to cover the whole area of the wired circuit pattern 4 except specified areas thereof which serve as the terminals portions, as shown in FIG. 1(h). The covering layer 6 is formed by a known method using solder resist of heat-resisting resist and the like. Thereafter, an overlapping plating layer formed of tin may further be formed on the tin plating layer 5 on the wired circuit pattern 4 exposed from the covering layer 6 to have the specified thickness, if necessary.

According to this process, when the tin plating layer 5 is formed by the electroless tin plating, the electroless tin plating solution contacts with the exposed end faces of the thin metal film 2 contacting with the wired circuit pattern 4 at the both widthwise sides thereof (Cf. FIG. 1(f)). However, even when the thin metal film 2 contacts with the electroless tin plating solution, since the thin metal film 2 is formed of nickel-chromium alloy having a chromium content of 8-20weight%, the thin metal film 2 is prevented from being melted by the electroless tin plating solution. This can produce the result that even when the wired circuit pattern 4 is formed at a fine pitch, the stripping of the lines of wire caused by the melting of the thin metal film 2 can be effectively prevented. This can produce the result of improved reliability of the flexible wired circuit board.

Although the embodiment wherein the thin metal film 2, the wired circuit pattern 4, the tin plating layer 5 and the covering layer 6 are sequentially formed on the insulating layer 1 has been illustrated above, it may be modified so that the insulating layer 1 is formed on a metal supporting layer 8 of a stainless foil and the like, first, and, then, the thin metal film 2, the wired circuit pattern 4, the tin plating layer 5 and the covering layer 6 are sequentially formed on the insulating layer 1 formed on the metal supporting layer 8, as shown in FIG. 1(i).

In the formation of the thin metal film 2, the thin metal film 2 may be formed in multilayer (two-layer) for example by forming the first thin metal film 9 of nickel-chromium alloy, first, and, then, laminating a second thin metal film 10 of copper on the first thin metal film 9, as shown in FIG. 1(j). The formation of the second thin metal layer 10 of copper can provide improved adhesion between the first thin metal film 9 and the wired circuit pattern 4.

In this variant, the second thin metal film 10 has a thickness of e.g. 1,000-3,000Å, or preferably 1,000-2,000Å. When the thickness of the second thin metal film 10 is less than 1,000Å, the wired circuit pattern 4 formed on the second thin metal film 10 by the electrolytic plating may have an inhomogeneous thickness. On the other hand, when the thickness of the second thin metal film 10 is more than 3,000Å, the productivity may be decreased.

In the process of forming the second thin metal film 10, for example after the second thin metal film 10 is formed on the whole area of the first thin metal film 9 by electroless plating or by vacuum deposition process or preferably by sputtering and, then, the plating resist 3 is formed in the pattern reverse to the wired circuit pattern 4 on the second thin metal film 10, the wired circuit pattern 4 is formed on the second thin metal film 10 by the electrolytic plating.

Sequentially, after the plating resist 3 is removed, parts of the second thin metal film 10 and first thin metal film 9 exposed from the wired circuit board 4 are sequentially removed by a known etching process, such as the chemical etching (wet etching).

In the electroless tin plating process, together with the respective lines of wire of the wired circuit pattern 4 of copper, the second thin metal film 10 of copper thus formed is etched at end faces thereof exposed from the both widthwise sides by substitution of tin for copper and is reduced in width. Then, the second thin metal film 10 reduced in width with respect to the width of the respective line of wire of the wired circuit pattern 4 is covered with the tin plating layer 5 at both widthwise end faces thereof, as shown in FIG. 1(j).

Although the production method of the wired circuit board of the present invention has been illustrated with an example of the production method of the flexible wired circuit board, the production method of the wired circuit board of the present invention is particularly suitably applicable to the production method of the wired circuit board such as the TAB tape carrier wherein the tin plating layer is formed as an electrode pad to mount IC or LSI.

### Examples

While in the following, the present invention will be described in further detail with reference to Examples and Comparative Examples, the present invention is not limited to any of the examples and comparative examples.

### Examples 1-8 and Comparative Examples 1 and 2

A metal supporting layer 8 of stainless foil (SUS304) having thickness of 20 *µ* m was prepared (Cf. FIG. 2(a)). Then, after polyamic acid resin solution was coated on the metal supporting layer 8 and dried, it was cured by heating to be imidized, so as to form the insulating layer 1 of polyimide having thickness of 25 *µ* m on the metal supporting layer 8 (Cf. FIG. 2(b)).

Sequentially, the first thin metal film 9 having a nickel/chromium content ratio and a thickness shown in TABLE 1 was formed on the insulating layer 1 by sputtering (Cf. FIG. 2(c)). Further, the second thin metal film 10 of copper having thickness of 2,000 Å is formed on the first thin metal film 9 by sputtering. The thin metal film 2 was formed in the manner mentioned above (Cf. FIG. 2(d)).

**TABLE 1**

| | Ni/Cr content ratio of first thin metal film (weight%) | Thickness of first thin metal film (Å) | Width of line of wire (*µ* m) |
|---|---|---|---|
| Example 1 | 80/20 | 300 | 15 |
| Example 2 | 80/20 | 300 | 10 |
| Example 3 | 80/20 | 70 | 15 |
| Example 4 | 80/20 | 70 | 10 |
| Example 5 | 85/15 | 300 | 15 |
| Example 6 | 85/15 | 300 | 10 |
| Example 7 | 92/8 | 300 | 15 |
| Example 8 | 92/8 | 300 | 10 |
| Comparative Example 1 | 0/100 | 300 | 15 |
| Comparative Example 2 | 100/0 | 300 | 15 |

Then, through holes (feed holes, not shown) were formed by punching at predetermined locations of the metal supporting layer 8, the insulating layer 1 and the thin metal film 2, to extend therethrough in the thickness direction thereof.

Then, a plating resist having a reverse pattern to the wired circuit pattern 4 was formed on the thin metal film 2 (Cf. FIG. 2(e)). Then, the wired circuit pattern 4 of copper whose lines of wire has a width shown in TABLE 1 and thickness of 10 *µ* m was formed on the surface of the thin metal film 2 exposed from the plating resist 3 (FIG. 2(f)).

Sequentially, after the plating resist 3 was removed (FIG. 2(g)), the thin metal film 2 under which the plating resist 3 had been formed was removed by etching (Cf. FIG. 2(h)).

Then, the tin plating layer 5 having thickness of 0.5 *µ* m was formed on the exposed surfaces of the wired circuit pattern 4 by the electroless tin plating in the conditions of at 65°C and for five minutes (FIG. 2(i)). Then, after the tin plating layer 5 was annealed at 125°C for ninety minutes, in order to prevent generation of whisker, the whole area of the wired circuit pattern 4, except predetermined areas thereof serving as the terminal portions, was covered with a thermosetting solder resist to form the covering layer (protective insulating layer) 6 (FIG. 2(j)).

Further, the whole area of the metal supporting layer 8, except predetermined areas thereof, was removed by etching so that the remaining areas of the metal supporting layer 8 could serve as a stiffener board (not shown). The TAB tape carrier was produced in the manner mentioned above.

### Evaluation

In the production processes mentioned above, the presence of the stripping of the wired circuit pattern after subjected to the electroless tin plating was observed. From this observation, it was found that no stripping of the wired circuit pattern was found in Examples 1-8, while on the other hand, the stripping of the wired circuit pattern was found in Comparative Examples 1 and 2.

While the illustrative embodiments of the present invention are provided in the above description, such is for illustrative purpose only and it is not to be construed restrictively. Modification and variation of the present invention that will be obvious to those skilled in the art is to be covered by the following claims.

## Claims

1. A wired circuit board comprising:
an insulating layer,
a thin metal film formed on the insulating layer and formed of nickel-chromium alloy having a chromium content of 8-20weight%,
a wired circuit pattern formed on the thin metal film and formed of copper, and
a tin plating layer formed on the wired circuit pattern by electroless tin plating.

2. The wired circuit board according to Claim 1, wherein each line of wire of the wired circuit pattern has a width of 15 *µ* m or less.

3. A production method of a wired circuit board comprising:
the process of preparing an insulating layer,
the process of forming on the insulating layer a thin metal film of nickel-chromium alloy having a chromium content of 8-20weight%,
the process of forming a wired circuit pattern of copper on the thin metal film, and
the process of forming a tin plating layer on the wired circuit pattern by electroless tin plating.

4. The production method of the wired circuit board according to Claim 3, wherein the wired circuit pattern is formed so that each line of wire of the wired circuit pattern has a width of 15 *µ* m or less
